# EUROPEAN PATENT SPECIFICATION

(11) **EP 1 435 658 B1**
(45) Date of publication and mention of the grant of the patent: **26.05.2010**
(21) Application number: 02779905.5
(22) Date of filing: 07.10.2002
(51) Int. Cl.: H01L 23/12, H05K 1/11

(54) **SUBSTRATES AND METHOD FOR PRODUCING THE SAME**
SUBSTRATE UND VERFAHREN ZU IHRER HERSTELLUNG
SUBSTRATS ET PROCEDE POUR LEUR PRODUCTION

(30) Priority: 10.10.2001 JP 2001312516
(43) Date of publication of application: 07.07.2004
(73) Proprietor: Tokuyama Corporation, Tokuyama-shi, Yamaguchi-ken 745-0053 (JP)
(72) Inventor: YAMAMOTO, Reo, Tokuyama-shi, Yamaguchi 745-0053 (JP); KAMIYAMA, Yoshihide, Tokuyama-shi, Yamaguchi 745-0053 (JP)
(74) Representative: Towler, Philip Dean
(86) International application number: PCT/JP2002/010414
(87) International publication number: WO 2003/034488

(56) References cited:
- EP-A- 1 100 298
- EP-A2- 0 987 748
- JP-A- 11 017 297
- JP-A- 2001 044 323
- US-A- 4 963 701
- US-A- 5 473 194
- US-A- 5 787 580
- US-A- 6 132 543
- PATENT ABSTRACTS OF JAPAN vol. 017, no. 528 (E-1437), 22 September 1993 (1993-09-22) & JP 05 145230 A (FUJITSU LTD), 11 June 1993 (1993-06-11)
- PATENT ABSTRACTS OF JAPAN vol. 016, no. 533 (C-1002), 4 November 1992 (1992-11-04) & JP 04 202074 A (TOSHIBA CORP), 22 July 1992 (1992-07-22)
- PATENT ABSTRACTS OF JAPAN vol. 015, no. 022 (E-1024), 18 January 1991 (1991-01-18) & JP 02 267989 A (NGK INSULATORS LTD), 1 November 1990 (1990-11-01) -& DATABASE WPI Week 199050 Derwent Publications Ltd., London, GB; AN 1990-371603 XP002398016 & JP 02 267989 A (NGK INSULATORS LTD) 1 November 1990 (1990-11-01)

## Description

### DETAILED DESCRIPTION OF THE INVENTION

### FIELD OF THE INVENTION

The present invention relates to a ceramic substrate having a via hole which can suitably be used as a submount, and a method of manufacturing the substrate.

### DESCRIPTION OF THE RELATED ART

A submount is an insulating substrate positioned between a semiconductor laser element or device and a heat sink (a block formed of a metal such as copper), and has such a performance that heat generated from the semiconductor laser element can efficiently be transmitted toward the heat sink side. A general submount for a semiconductor laser element has a circuit pattern provided on the upper and lower surfaces of a ceramic substrate, and circuit patterns provided on the upper and lower surfaces are electrically connected to each other through a conductive via hole penetrating through the upper and lower surfaces. For use, an element such as a semiconductor laser is bonded to one of the surfaces and a heat sink is bonded to the other surface through a solder.

In the case of manufacturing such submount generally, there is employed a method of forming a through hole on a plate-shaped molded product (a green sheet) containing ceramic powder, filling a paste containing a conductive material therein, and then sintering the ceramic powder and the conductive material (such a method is referred to as a co-fired method), and thereafter polishing a surface and subsequently metallizing the whole surface of the ceramic substrate to form a conductive layer, thereby forming a circuit pattern by a lithography process. More specifically, a photoresist is applied onto the conductive layer covering the whole surface of the substrate, an exposing step using the mask of a circuit pattern, a developing and rinsing step and optionally a postbaking step are carried out and an unnecessary conductive layer is then removed at an etching step, and furthermore, the resist is peeled away so that the circuit pattern is formed. In some cases, in a surface on the side where an element is to be mounted, the circuit pattern may be formed by the conductive layer covering the whole surface depending on a mounting manner. Also in these cases, the positional relationship between a portion on which the element is to be actually mounted and a via hole present on an underlaid portion should be sometimes controlled. In the case in which the element is to be soldered by a reflow method, for example, it is necessary to form a solder film pattern for bonding the element in the predetermined position of the circuit pattern.

In the former case in which the circuit pattern is formed by the lithography process, the via hole filled with the conductive material (since a metal is often used as the conductive material, such a via hole will be hereinafter referred to as a metallic via hole) is provided for the electrical connection of the circuit patterns formed on both sides of the ceramic substrate. Therefore, the circuit pattern is formed to cover the whole surface of the metallic via hole exposed on the surface of the ceramic substrate (in more detail, the surface of the exposed portion of the conductive material filled in the via hole) and a periphery thereof. In this case, if the positioning of a mask (a photomask) of the circuit pattern is not accurately carried out at the exposing step in a circuit pattern forming process and the positioning thereof is shifted, the contact area of the metallic via hole and the circuit pattern formed on the surface of the ceramic substrate is reduced so that a defective product is caused by an increase in an electric resistance, connecting failures and the like. For this reason, it is necessary to accurately carry out the positioning of the mask. Also in the latter case in which the circuit pattern is formed by a conductive layer covering the whole surface, moreover, it is important that a mask for forming a solder film is positioned accurately.

Examples of a method of carrying out such positioning include a mechanical matching method using a mechanical reference pin and a pattern recognizing method. In the case in which precision in a position from the end of the substrate to the metallic via hole is low, the case in which the end of the substrate is deformed or the case in which a shape is modified, it is hard to apply the former method. For this reason, the pattern recognizing method is generally employed. In the pattern recognizing method, a marker for positioning is formed on substrate, and monitoring relative position between a photomask or a mask for forming a solder film pattern and the marker, to thereby finely adjusting the shift therebetween and to thus carry out matching. This method can be conducted automatically.

### PROBLEMS TO BE SOLVED

In recent years, however, a reduction in a size and high density mounting have been required for the submount with an increase in a performance and a reduction in a size of an electronic apparatus. Since the positional relationship between a metallic via hole and a circuit pattern and precision have been strict. In the manufacture, therefore, the utilization of the marker for positioning is not sufficient in many cases. For this reason, the position is finely adjusted with eyes based on the trace of the metallic via hole present on an underlaid portion which appears on the surface of the conductive layer. However, the diameter of the metallic via hole is very small, that is, 0.03 to 0.50 mm and the metallic via hole is therefore hard to discriminate, and skill is required for confirming a position thereof. In the case in which a person who does not get skilled in an operation carries out the positioning, the shift of the positions of the circuit pattern and the metallic via hole is often generated.

Therefore, it is an object of the present invention to provide "a double-sided circuit board having a metallic via hole" which can suitably be used as a submount for mounting a semiconductor device, that is, a substrate in which the electrical connection of a metallic via hole and a circuit pattern is excellent and an element can easily be bonded and positioned, and a method of efficiently manufacturing the substrate.

### MEANS FOR SOLVING THE PROBLEMS

The present inventors earnestly made studies in order to solve the problems of the conventional art. More specifically, in the case in which a conductive layer is formed on a substrate, generally, it is supposed that the surface of the substrate is preferably smooth in respect of the adhesion of the substrate and the conductive layer. On the other hand, they supposed that the position of a metallic via hole might easily be confirmed also after the conductive layer is formed if a metallic via hole portion is artificially protruded to form the conductive layer. Consequently, they earnestly investigated the conditions for forming a protruded portion which can be discriminated while maintaining a reliability when directly mounting a semiconductor device on the metallic via hole without deteriorating the adhesion of the conductive layer. As a result, it was found that objective advantages can be obtained in the case in which the surface roughness of a ceramic substrate is set to have a specific value or less, and furthermore, the metallic via hole is protruded from the surface of the substrate with a specific height. Consequently, the present invention was finished.

More specifically, a first aspect of the present invention is directed to a substrate for element mounting in which a conductive layer which covers a whole surface of an exposed portion of a conductive material filled in a via hole is formed on a surface of a ceramic substrate, wherein a ceramic portion of a face of the ceramic substrate on which an element is to be mounted has a surface roughness of Ra ≦ 0.8µm and the conductive material filled in the via hole present on the face for mounting the element is protruded from a surface of the face with a height of 0.3 to 5.0µm.

The substrate according to the first aspect of the invention (which will be hereinafter referred to as a product substrate according to the present invention) can suitably be used as a submount. The product substrate according to the present invention has such advantages that die bonding can be carried out with a high reliability when an element is mounted and a substrate with high reliability can be obtained easily and efficiently by using a lithography process. Moreover, in the product substrate according to the present invention which has the conductive layer covering the whole face on the side of the ceramic substrate where the element is to be mounted, the position of a metallic via hole present on an underlaid portion can easily be confirmed and a relative positional relationship with the metallic via hole can arbitrarily be controlled to form a solder film pattern for element bonding on the conductive layer. Such a substrate provided with the solder film pattern has such advantages that an element can easily be bonded and positioned and the element can be bonded onto a predetermined position with high precision.

Moreover, a second aspect of the present invention is directed to a ceramic substrate having a via hole filled with a conductive material, wherein a ceramic portion on at least one of faces of the ceramic substrate has a surface roughness of Ra ≦ 0.8 µm, the conductive material filled in the via hole present on at least one of the faces of the ceramic portion which has the surface roughness of Ra ≦ 0.8µm is protruded from the surface of the face with a height of 0.3 to 5.0µm, and the conductive layer is formed on neither of upper and lower faces of the ceramic substrate.

The substrate according to the second aspect of the invention (which will be hereinafter referred to as a material substrate according to the present invention) can suitably be used as the material substrate when manufacturing the product substrate according to the present invention which can suitably be used as the submount. The material substrate has such advantages that the position of a metallic via hole can easily be confirmed with eyes even if the conductive layer is formed on the surface.

Furthermore, a third aspect of the present invention is directed to a method of manufacturing the product substrate according to the present invention, comprising the steps of forming a conductive layer which wholly covers at least one of faces on which a conductive material filled in a via hole of the material substrate according to the present invention is protruded from a surface of a ceramic portion of the substrate with a height of 0.3 to 5.0µm, removing a part of the conductive layer by a lithography process to form a conductive layer which covers a whole surface of an exposed portion of the conductive material which is protruded, wherein positioning of a photomask at an exposing step in the lithography process is carried out based on a position of a convex portion of the conductive layer which results from the via hole present on an underlaid portion of the conductive layer. A fourth aspect of the present invention is directed to a method of manufacturing the product substrate according to the present invention, comprising the steps of forming a conductive layer which wholly covers at least one of faces on which a conductive material filled in a via hole of the material substrate according to the present invention is protruded from a surface of a ceramic portion of the substrate with a height of 0.3 to 5.0µm, confirming a position of the via hole present on an underlaid portion of the conductive layer based on a position of a convex portion of the conductive layer which results from the via hole, and forming a solder film pattern for element bonding on the conductive layer. According to the manufacturing methods of the present invention, it is possible to efficiently manufacture the product substrate of the present invention.

### BRIEF DESCRIPTION OF THE DRAWINGS

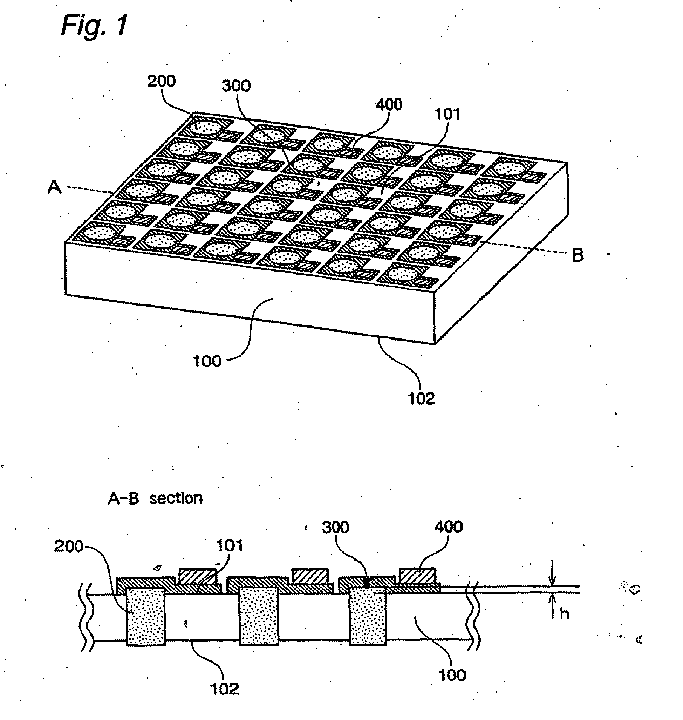

Fig. 1 is a perspective view and a vertical sectional view showing a typical embodiment of a product substrate according to the present invention.

### Explanation of Designations

100 : ceramic substrate
101 : element mounting surface
102 : surface on opposite side of element mounting surface
200 : metallic via hole
300 : conductive layer
400 : solder film pattern
h : protrusion height of via hole

### DETAILED DESCRIPTION OF PREFERRED EMBODIMENT

As described above, substrates according to the present invention (a material substrate and a product substrate of the present invention) have a common feature that a ceramic portion, which is on a surface to be the element mounting surface of a ceramic substrate including a metallic via hole, has a surface roughness of Ra ≦ 0.8 µm, and furthermore, a conductive material filled in the via hole is protruded from the surface of the element mounting surface with a height of 0.3 to 5.0µm. By such a feature, the position of the metallic via hole can easily be confirmed with eyes even if the whole surface of the ceramic substrate is covered with a conductive layer. In addition, the adhesion strength of the conductive layer is maintained to be sufficiently high, and furthermore, a reliability can be maintained when a semiconductor device is mounted. In the case where the height of the protrusion is less than 0.3µm, it is hard to confirm, with eyes, the position of the metallic via hole when the whole surface of the substrate is covered with the conductive layer. In the case where the height of the protrusion is more than 5.0µm, moreover, a large difference in level is formed between the conductive layer provided on the metallic via hole and the conductive layer provided therearound when the whole surface of the substrate is covered with the conductive layer. In particular, an adhesion is deteriorated in the vicinity of the boundary therebetween. Consequently, there is a possibility that an electrical conduction failure might be generated when a circuit pattern is formed. When the surface roughness of the ceramic portion is set to be Ra > 0.8µm, a reliability is deteriorated in the mounting of an element such as a semiconductor laser. In respect of the advantages described above, it is particularly preferable that the height of the protrusion should be preferably 0.3 to 1.8µm and the surface roughness should be preferably Ra ≦ 0.05 µm.

Among the substrates according to the present invention having aforementioned features, a substrate provided with a conductive layer which covers the whole surface of the exposed portion of a conductive material filled in a via hole protruded from the surface of a ceramic substrate (the product substrate according to the first aspect of the invention) itself can suitably be used as a submount and a substrate having no conductive layer on the surface (the material substrate according to the second aspect of the invention) can suitably be used as a material substrate for manufacturing the product substrate according to the first aspect of the invention.

Fig. 1 shows a typical structure of the product substrate according to the present invention in which a solder film pattern for element mounting is formed. The substrate includes an element mounting surface 101 having a surface roughness of Ra ≦ 0.8 µm, and the whole surface of a via hole protrusion of a ceramic substrate 100 having a via hole (metallic via hole) 200 filled with a conductive material and the surface of the ceramic substrate in the vicinity thereof are covered with a conductive layer 300, and a solder film pattern 400 for element mounting is formed on the conductive layer 300. The end face of the metallic via hole 200 is exposed in a perspective view of Fig. 1, but this merely indicates the position of the metallic via hole 200, and an upper surface thereof is covered with the conductive layer 300 as shown in a sectional view of Fig. 1. Moreover, the conductive layer may be formed on a surface 102 provided on the opposite side of the element mounting surface 101, which is not shown. Furthermore, the via hole 200 has a protrusion height h of 0.3 to 5.0µm from the surfaces 101 and 102. The material substrate according to the present invention has such structure indicated by excluding the conductive layer 300 and the solder film pattern 400 for element mounting from the product substrate shown in Fig. 1.

For the ceramic substrate to be used in the material substrate and the product substrate according to the second, resp. first, aspect of the invention, well-known materials can be used without limit. More specifically, aluminum nitride, beryllium oxide, silicon carbide, alumina, mullite, boron nitride and borosilicate glass are used. In particular, aluminum nitride has a high thermal conductivity. Therefore, when aluminum nitride is used for a submount, for example, heat generated from a semiconductor laser element can be efficiently let out toward a heat sink. In addition, since aluminum nitride also has a low dielectric constant and a coefficient of thermal expansion which is equal to that of the material of a semiconductor laser element such as Si, it can be used particularly suitably. When the substrate is used as a submount for mounting a semiconductor laser element, it is suitable that the ceramic substrate should have a high thermal conductivity, that is, 170 W/mK or more, and particularly 200 W/mK or more.

The ceramic substrate to be used in the material substrate and the product substrate according to the second, resp. first, aspect of the invention are provided with a via hole filled with a conductive material. A well-known conductive material is used without limit. In general, it is possible to suitably use tungsten, molybdenum, copper, silver, gold, nickel, palladium and the like. In the case where the substrate according to the present invention is manufactured by the co-fired method, particularly, tungsten and molybdenum can suitably be used in respect of a heat resistance. The dimension, shape and number of the via holes are arbitrarily selected, and furthermore, the outside dimension of the substrate is not limited. Moreover, when a conductive layer is formed in the ceramic substrate, the via hole does not need to penetrate through the ceramic substrate, and the hole may have such a depth as to reach the conductive layer. Furthermore, the conductive material does not need to be filled to completely bury the via hole but may be filled to cover an internal surface. However, it is suitable that a via hole should be filled with the conductive material to completely bury a hole (a through hole) penetrating through the upper and lower surfaces of the ceramic substrate because of easy manufacture. In this case, the via hole is usually formed by filling a paste containing the conductive material in the through hole. In respect of the filling property of the paste in that case, the diameter of the through hole is preferably 0.03 to 0.5 mm, and more preferably 0.05 to 0.4 mm. Moreover, it is preferable that the ratio of a length and a diameter (length / diameter) should be 40 or less. Furthermore, while the electric resistance of the via hole filled with the conductive material is not particularly restricted, it is preferably 0.5Ω or less, and more preferably 0.1Ω or less in order to fully reveal the performance of the semiconductor laser element.

In the product substrate according to the present invention, while the conductive layer to be formed to cover the whole surface of the exposed portion of the conductive material filled in the via hole in the surface for mounting the element is not particularly restricted as far as it is a conductive film substance, a metallic thin film or a thick film comprising metal powder and an inorganic or organic binder is usually used. In particular, the metallic thin film has a high electric conductiveness and is therefore used most suitably. While a well-known metal can be used for the metallic thin film without particular limitation, titanium, chromium, molybdenum, tungsten, tungsten titanium, aluminum, nickel chromium, tantalum and tantalum nitride are suitably used because of a high adhesion to the ceramic substrate. These metals may be used singly or in combination of two or more. Moreover, the conductive layer may be a single layer or two or more layers may be combined. In the case where the conductive layer has multi-layered structure, aforementioned metal can be used suitably for a first layer to directly come in contact with the ceramic substrate because of a high adhesion to the ceramic substrate. The well-known metals can be used for a second layer to be provided on the first layer. In the case where a circuit pattern having a two-layered film is used and the second layer is an uppermost layer, at least one of platinum, nickel, palladium, copper, silver and gold can suitably be used because of an excellent electric conductiveness. In the case where a film is further provided on the second layer and a circuit pattern having three layers or more is used, as the second layer material, it is possible to more suitably use platinum, nickel, palladium, tungsten, tungsten titanium or molybdenum which has a high diffusion preventing capability in order to prevent the diffusion of an element between the first and third layers and to maintain a stable adhesion strength between the circuit pattern and the ceramic substrate. The well-known metals can be used for the third layer, and at least one of platinum, nickel, palladium, copper, silver and gold can suitably be used because of an excellent electric conductiveness, for example. Since platinum, palladium, silver and gold particularly have an excellent corrosion resistance, moreover, they can be used more suitably. In order to easily solder a semiconductor device onto the metal layer to be the uppermost layer, furthermore, at least one solder film, for example, a gold - tin based solder, a lead - tin based solder, a gold - silicon based solder or a gold - germanium based solder may be laminated and patterned.

A method of manufacturing the material substrate according to the present invention is not particularly restricted except that the surface roughness of the ceramic substrate and the protrusion height of the metallic via hole are controlled to be set within the range described above, and a conventional well-known method can be employed. For example, the material substrate according to the present invention can be obtained by a so-called co-fired method comprising the steps of directly filling a paste containing a conductive material in a through hole of a green sheet provided with the through hole and sintering ceramic powder and a conductive material at the same time. Alternatively, the material substrate can also be obtained by a so-called post-fired method comprising the steps of forming a through hole on a sintered sheet by using a laser or the like and then filling a paste containing a conductive material to carry out re-sintering. The material substrate obtained in any method can be manufactured suitably by polishing the surface of the substrate. A well-known technique can be used for a polishing method without particular limitation and a method such as wrapping, polishing, barrel polishing, sand blast or polishing using a grinding machine is usually used.

In this case, the method of setting the surface roughness of the ceramic substrate to be Ra ≦ 0.8µm, and furthermore, setting the protrusion height of the metallic via hole to be 0.3 to 5.0µm is not particularly restricted. For example, it is possible to employ (i) a method comprising the steps of sintering a green sheet provided with a through hole and then filling a paste containing a conductive material slightly excessively in the through hole to carry out re-sintering, and thereafter controlling polishing conditions in such a manner that the surface roughness of the surface of the substrate and the protrusion height of the metallic via hole are set within the above-mentioned range, (ii) a method comprising the steps of making holes in the surface of the fired substrate by using a laser or the like and then polishing the surface of the substrate to have the surface roughness of Ra ≦ 0.8µm and thereafter filling a paste containing a conductive material slightly excessively in a through hole to carry out re-sintering, and subsequently carrying out polishing in such a manner that the metallic via hole has the protrusion height set within the above-mentioned range, and (iii) a method comprising the steps of directly filling a paste containing a conductive material in a through hole of a green sheet provided with the through hole and then carrying out co-firing, and thereafter controlling polishing conditions in such a manner that the surface roughness of the surface of the substrate and the protrusion height of a metallic via hole are set within the above-mentioned range. It is the most suitable that the method (iii) is employed because of the small number of steps and economical advantages.

In the ceramic substrate including the via hole fired as described above, generally, the conductive material filled in the via hole is harder than that in a ceramic substrate constituted by a material such as ceramic. In the case where the whole surface is polished by using abrasive grains (abrasive), therefore, the soft ceramic substrate portion is more polished and the hard metallic via hole portion is protruded. For this reason, if the polishing using small abrasive grains is continuously carried out to obtain a surface roughness of Ra ≦ 0.8µm, preferably Ra ≦ 0.05µm in which a high reliability is generally obtained in the mounting of a semiconductor laser element, the protrusion height of the metallic via hole is excessively increased. Based on a knowledge that the above-mentioned tendency is reduced by using large abrasive grains and is increased by using small abrasive grains, the present inventors successfully obtained a material substrate satisfying the above-mentioned requisites by first carrying out polishing using large abrasive grains to reduce the surface roughness of the ceramic substrate to some extent while preventing the amount of protrusion of the metallic via hole, then carrying out the polishing using small abrasive grains to more reduce the surface roughness of the ceramic substrate while adjusting the amount of protrusion of the metallic via hole in order to decrease the surface roughness of the ceramic substrate and to set the amount of protrusion of the metallic via hole within a proper range. Such polishing is not restricted to two stages but can also be carried out by several times using abrasive grains having several grain sizes. Polishing conditions in each stage cannot be generally defined because they are varied depending on the materials of a ceramic substrate and a conductive material which are to be used, the diameter of a via hole and the like. However, the polishing conditions can easily be determined by carrying out the polishing with a variation in the size of the abrasive grains for each system and a time required for the polishing and checking the relationship among these conditions, the amount of protrusion of the metallic via hole and the surface roughness of the ceramic substrate.

The material substrate according to the second aspect of the invention which is thus manufactured can suitably be used as an intermediate material when producing the product substrate according to the first aspect of the invention by the following method because the position of the via hole can easily be confirmed with eyes from the surface of a thin film conductive layer even if the thin film conductive layer is formed on the surface. More specifically, the product substrate according to the first aspect of the invention can suitably be manufactured by (1) covering, with a conductive layer, a surface for mounting the element of the material substrate of the present invention, that is, a whole surface provided on the side where the metallic via hole is protruded with a height of 0.3 to 5.0µm is covered with a conductive layer, and then positioning a photomask at an exposing step in a lithography process based on the position of the convex portion of a conductive layer resulting from the protruded metallic via hole which is present on the underlaid portion of the conductive layer, thereby removing a part of the conductive layer by using the lithography process so as to remain the conductive layer covering at least the whole surface of the exposed portion of the protruded metallic via hole or (2) covering, with the conductive layer, a surface for mounting the element of the material substrate of the present invention, that is, the whole surface provided on the side where the metallic via hole is protruded with a height of 0.3 to 5.0µm is covered with a conductive layer, and then confirming the position of the via hole present on the underlaid portion of the conductive layer based on the position of the convex portion of the conductive layer which results from the via hole, thereby forming, on the conductive layer, a solder film pattern for element bonding.

The lithography process to be employed in the method (1) is one of typical pattern forming methods, in which a substrate is coated with an organic resist having an excellent etching resistance, or a dry film is stuck and then circuit pattern is printed on resist film by using an optical transferring technique or the like, and a conductive layer is etched by using the resist pattern as a mask, thereby forming a circuit pattern. Basically, the method comprises ① the step of coating (sticking) a resist on a washed substrate, ② the exposing step for printing a pattern into the resist by using a photomask, ③ the developing and rinsing step, ④ the etching step, and ⑤ the resist removing step.

In the lithography process of the manufacturing method, the positioning of the photomask at the exposing step is carried out based on the position of the convex portion of the conductive layer which results from the metallic via hole protruded from the material substrate. Consequently, it is possible to reduce the incidence of a defective product caused by the shift of the position of the photomask.

In the above method, the conductive layer which is formed to cover the whole surface on the side where the metallic via hole of the material substrate is protruded with a height of 0.3 to 5.0µm is partially removed by etching to left the conductive layer so as to cover the whole exposed surface of the metallic via hole. Consequently, it is possible to obtain the product substrate according to the first aspect of the invention which has a circuit pattern having a desirable shape. Accordingly, the circuit pattern formed by the remaining conductive layer has a basically identical structure to that of the conductive layer described in relation to the product substrate according to the first aspect of the invention. It is also possible to selectively form a metallized layer onto the remaining conductive layer obtained by the execution of the etching. In the case where the conductive layer to finally act as the circuit pattern has a lamination structure, therefore, at least a lowermost layer may be formed by etching. For the method of forming the conductive layer, it is possible to employ, without particular limitation, well-known film forming methods such as a physical evaporation process, a chemical evaporation process, a spraying process, a noneletrolytic plating process, a fusion plating process, an anodic oxidation process and a film coating process.

Moreover, the lithography process to be employed in the present invention is the same as the conventionally used lithography process except that the positioning of the photoresist is carried out based on the position of the convex portion of the conductive layer which results from the protruded metallic via hole of the material substrate according to the present invention. More specifically, various materials and chemicals such as a resist, a photomask and a resist remover which are used in the general lithography process can be utilized without particular limitation and the conditions of use are not particularly restricted.

Furthermore, the formation of the solder film pattern in the method (2) can be carried out by positioning and mounting, on the conductive film of the substrate, a mask formed of a metal plate lacking a portion corresponding to the solder film pattern based on the position of the convex portion of the conductive layer which results from the protruded metallic via hole, forming a solder film by evaporation or sputtering and then removing the mask. By employing such a method, it is also possible to selectively form a solder film layer on only a portion in which the metallic via hole is not present under the conductive layer. Also in the case wherein the circuit pattern having the desirable shape is formed by the method (1) as shown in Fig. 1, it is a matter of course that the solder film layer can also be formed selectively on only the portion in which the metallic via hole is not present under the conductive layer in the same manner.

### EXAMPLES

While examples will be described below for more specific explanation of the present invention, the present invention is not restricted to these examples.

### EXAMPLE 1

5 parts by weight of yttrium oxide powder, 15 parts by weight of butyl methacrylate as an organic binder and a dispersing agent and 5 parts by weight of dioctyl phthalate as a plasticizer were added to 100 parts by weight of aluminum nitride powder, and were mixed by using toluene as a solvent by means of a ball mill. The slurry was defoamed and was then formed into a sheet having a thickness of 0.6 mm by a doctor blade method. A sheet having a length of 60 mm and a width of 60 mm was cut out of the green sheet and was provided with 42 x 42 through holes having a diameter of φ250µm at a pitch of 1.3 mm in all directions by means of a metal mold for punching. Next, a tungsten paste was filled in the through hole by a press injection method. For the filling conditions, 45 psi and 120 seconds were set. An aluminum nitride green sheet product having a tungsten via hole thus fabricated was heated and dewaxed at 900°C for 2 hours while circulating a dry nitrogen gas at 30 litre / minute. A temperature rising rate was 2°C / minute. At the same time, the carbon residue rate of a dewaxed product as a test sample was measured as 1950 ppm. Then, the dewaxed product was put in a container formed of aluminum nitride and was heated at 1615°C for 4 hours in a nitrogen atmosphere, and furthermore, was fired at 1870°C for 9 hours. Consequently, there was obtained an aluminum nitride substrate having a length of 48 mm, a width of 48 mm and a thickness of 0.48 mm which is provided with a tungsten via hole having a diameter of φ200µm. The substrate had a warpage of 35µm. At the same time, the thermal conductivity of a test sample having a thickness of 0.48 mm of the dewaxed and fired substrate was measured as 210 W/mK by a laser flash method.

The surface of the aluminum nitride substrate having the tungsten via hole was polished for 30 minutes by means of abrasive grains having a size of 360µm and was then polished for one hour and 20 minutes by means of abrasive grains having a size of 120µm. Consequently, there was obtained the material substrate according to the present invention in which the plane of the aluminum nitride substrate has a surface roughness of Ra = 0.027µm and the tungsten via hole protruded from the surface of the substrate has a height of 0.8µm.

Next, a thin film conductive layer having a structure of first/second/third layers = titanium : 0.1µm / platinum : 0.2µm / gold : 0.5µm was formed over the whole both sides of the substrate by sputtering and subsequently a gold - tin (gold = 80 wt%) based solder film pattern (a thickness of 5µm) was formed in a pattern over the surface such that a via hole is not present under the pattern by evaporation using a metal mask. Since the position of the tungsten via hole could be confirmed as the position of the convex portion of the conductive layer, the positioning of the metal mask could easily be carried out. Next, the substrate provided with the conductive layer and the solder film layer was cut into a 1.3 mm square like a chip. For all the cut pieces, the positional relationship between the solder film pattern and the via hole was checked. Consequently, it was found that the via hole is not present under the solder film pattern.

Next, a nail head pin plated with nickel was vertically soldered to a portion positioned just above the tungsten via hole over the conductive layer. The nail head pin has a nail head diameter of 1.1 mm and a pin diameter of 0.5 mm and is made of 42-alloy. The solder has a composition of lead - tin (lead = 40 wt%). This was set into Strograph M2 manufactured by TOYO SEIKI SEISAKUSHO Co., Ltd. When the nail head pin was pulled in a vertical direction, a breaking strength, that is, an adhesion strength of the conductive layer was measured as 13.0 kg/mm². A peeling mode was in-solder breakdown.

Furthermore, one of the sides of the chip was soldered to a copper plate by using a solder having the same composition as that used in the evaluation of the adhesion strength and four terminals were put on the other side. Thus, an electric resistance of the via hole was measured as 0.013Ω (a measured mean value of 10 chips).

### COMPARATIVE EXAMPLE 1

The surface of the aluminum nitride substrate having the tungsten via hole which was fabricated in the example 1 was polished for one hour and 50 minutes by using only abrasive grains having a size of 360µm. Consequently, there was obtained a material substrate in which the surface of the substrate has a surface roughness of Ra = 0.043µm and the tungsten via hole was protruded from the surface of the aluminum nitride substrate with a protrusion height of 0.1µm. In the same manner as in the example 1, next, a conductive layer and a solder film pattern were formed on the surface of the material substrate. Since the position of the via hole could not be confirmed with eyes from above the conductive layer and the solder film layer, the positioning of a metal mask was carried out based on one corner of the substrate. Subsequently, the substrate provided with the conductive layer and the solder film layer was cut in the same manner as in the example 1 and the positional relationship between the solder film pattern and the tungsten via hole was checked for all the cut pieces. Consequently, it was found that 419 defective chips having the tungsten via holes under the solder film pattern were present. Moreover, an adhesion strength of the conductive layer was measured as 10.5 kg/mm² and a peeling mode was in-solder breakdown. Furthermore, an electric resistance of the via hole was measured as 0.025Ω (a measured mean value of 10 chips).

### COMPARATIVE EXAMPLE 2

The surface of the aluminum nitride substrate having the tungsten via hole which was fabricated in the example 1 was polished for three hours and 40 minutes by using only abrasive grains having a size of 120µm. Consequently, there was obtained a material substrate in which the surface of the substrate has a surface roughness of Ra = 0.041µm and the tungsten via hole was protruded from the surface of the substrate with a protrusion height of 6.5µm. In the same manner as in the example 1, next, a conductive layer and a solder film pattern were formed on the surface of the substrate. The position of the via hole could be confirmed from the position of the convex portion of a metallized layer, the positioning of a metal mask could easily be carried out. The positional relationship between the solder film pattern and the via hole was checked. Consequently, there was not a via hole under the solder film pattern. Moreover, an adhesion strength of the conductive layer which was measured was as low as 2.1 kg/mm² and a peeling mode was substrate / thin film conductive layer interface breakdown. However, an electric resistance of the via hole which was measured was as high as 0.55Ω (a measured mean value of 10 chips), and a partial conduction failure was generated.

### ADVANTAGE OF THE INVENTION

According to the present invention, the protrusion height of a via hole filled with a conductive material is restricted to a certain height from the plane of a ceramic substrate. Consequently, the position of the via hole can be confirmed with eyes also after metallization and the positioning of a mask for forming a circuit pattern can easily be carried out.

## Claims

1. A substrate (100) for element mounting in which a conductive layer (300) which covers a whole surface of an exposed portion of a conductive material filled in a via hole (200) is formed on a surface (101) of a ceramic substrate (100), **characterized in, that** a ceramic portion of a face of the ceramic substrate on which an element is to be mounted has a surface roughness of Ra ≦ 0.8µm and the conductive material filled in the via hole present on the face for mounting the element is protruded from a surface of the face with a height of 0.3 to 5.0µm.

2. The substrate according to claim 1, wherein a solder film pattern (400) for element bonding is formed on the conductive layer which covers the whole face for mounting the element of the ceramic substrate.

3. A ceramic substrate (100) that can suitably be used for manufacturing a substrate as defined in claim 1, and having a via hole (200) filled with a conductive material, **characterized in, that** a ceramic portion on at least one of the faces (101, 102) of the ceramic substrate has a surface roughness of Ra ≦ 0.8µm, the conductive material filled in the via hole present on at least one of the faces of the ceramic portion which has the surface roughness of Ra ≦ 0.8µm is protruded from the surface of the face with a height of 0.3 to 5.0µm, and the conductive layer is formed on neither of upper and lower faces of the ceramic substrate.

4. A method of manufacturing the substrate according to claim 1, comprising the steps of:
forming a conductive layer which wholly covers at least one of faces on which a conductive material filled in a via hole of the substrate according to claim 3 is protruded from a surface of a ceramic portion of the
substrate with a height of 0.3 to 5.0µm,
removing a part of the conductive layer by a lithography process, to form a conductive layer which covers a whole surface of an exposed portion of the conductive material which is protruded,
wherein positioning of a photomask at an exposing step in the lithography process is carried out based on a position of a convex portion of the conductive layer which results from the via hole present on an underlaid portion of the conductive layer.

5. A method of manufacturing the substrate according to claim 2, comprising the steps of:
forming a conductive layer which wholly covers at least one of faces on which a conductive material filled in a via hole of the substrate according to claim 3 is protruded from a surface of a ceramic portion of the substrate with a height of 0.3 to 5.0µm,
confirming a position of the via hole present on an underlaid portion of the conductive layer based on a position of a convex portion of the conductive layer which results from the via hole, and forming a solder film pattern for element bonding on the conductive layer, in relative positional relationship with said via hole.

## Patentansprüche

1. Substrat (100) zur Element- bzw. Bauteilmontage, bei dem eine leitende Schicht (300), welche eine Gesamtoberfläche eines exponierten Teils eines leitenden Materials, das in ein Durchgangsloch (200) gefüllt ist, bedeckt, auf einer Oberfläche (101) eines keramischen Substrats (100) ausgebildet ist, **dadurch gekennzeichnet, dass** ein keramischer Teil einer (Anlage-) Fläche des keramischen Substrats, auf welcher ein Element anzubringen ist, eine Oberflächenrauhigkeit von Ra ≤ 0,8 µm aufweist und das leitende Material, das in das Durchgangsloch gefüllt ist, welches auf der Fläche zur Anbringung des Elements vorliegt, von einer Oberfläche der Fläche mit einer Höhe von 0,3 bis 5,0 µm vorspringt.

2. Substrat nach Anspruch 1, bei dem ein Lötfilmmuster (400) zur Bauteilbefestigung auf der leitenden Schicht ausgebildet ist, welches die gesamte Fläche zur Montage des Elements auf der keramischen Oberfläche bedeckt.

3. Keramisches Substrat (100), das in geeigneter Weise zur Herstellung eines Substrats wie in Anspruch 1 definiert verwendet werden kann, und das ein Durchgangsloch (200) aufweist, das mit einem leitenden Material gefüllt ist, **dadurch gekennzeichnet, dass** ein keramischer Teil auf wenigstens einer der Flächen (101, 102) des keramischen Substrats eine Oberflächenrauhigkeit von Ra ≤ 0,8 µm aufweist, wobei das leitende Material, das in das Durchgangsloch gefüllt ist, das auf wenigstens einer der Flächen des keramischen Teils vorliegt, welche die Oberflächenrauhigkeit von Ra ≤ 0,8 µm aufweist, von der Oberfläche der Fläche mit einer Höhe von 0,3 - 5,0 µm vorspringt, und die leitende Schicht auf weder oberen noch unteren Flächen des keramischen Substrats ausgebildet ist.

4. Verfahren zur Herstellung des Substrats nach Anspruch 1, das die Schritte beinhaltet:
Ausbilden einer leitenden Schicht, welche wenigstens eine der Flächen vollständig bedeckt, auf welchen ein leitendes Material, das in ein Durchgangsloch des Substrats nach Anspruch 3 gefüllt ist, von einer Oberfläche eines keramischen Abschnitts des Substrats mit einer Höhe von 0,3 - 5,0 µm vorspringt,
Entfernen eines Teils der leitenden Schicht durch einen Lithographieprozess zum Ausbilden einer leitenden Schicht, welche eine vollständige Oberfläche eines exponierten Teils des leitenden Materials, welcher vorspringt, bedeckt,
wobei die Positionierung einer Fotomaske bzw. -schablone in einem Expositionsschritt in dem Lithographieprozess auf Grundlage einer Position eines konvexen Teils der leitenden Schicht ausgeführt wird, welcher aus dem Durchgangsloch, das auf einem darunter liegenden Teil der leitenden Schicht vorliegt, resultiert.

5. Verfahren zur Herstellung des Substrats nach Anspruch 2, das die Schritte beinhaltet:
Ausbilden einer leitenden Schicht, welche wenigstens eine der Flächen vollständig bedeckt, auf welchen ein leitendes Material, das in ein Durchgangsloch des Substrats nach Anspruch 3 gefüllt ist, von einer Oberfläche eines keramischen Abschnitts des Substrats mit einer Höhe von 0,3 - 5,0 µm vorspringt,
Bestätigen einer Position des Durchgangslochs, das auf einem darunterliegenden Teil der leitenden Schicht vorliegt, auf Grundlage einer Position eines konvexen Abschnitts der leitenden Schicht, welche aus dem Durchgangsloch resultiert, und
Ausbilden eines Lötfilmmusters zur Bauteilbefestigung auf der leitenden Schicht in relativer positioneller Beziehung zu dem Durchgangsloch.

## Revendications

1. Substrat (100) pour le montage d'élément, dans lequel une couche conductrice (30) qui couvre une surface entière d'une portion exposée d'un matériau conducteur remplissant un trou d'interconnexion (200) est formée sur une surface (101) d'un substrat en céramique (100) **characterised in that,** et une portion en céramique d'une face du substrat en céramique sur lequel un élément doit être monté présente une rugosité de surface Ra ≤ 0,8 µm et en ce que le matériau conducteur remplissant le trou d'interconnexion présent sur la face pour le montage de l'élément fait saillie à partir d'une surface de la face avec une hauteur de 0,3 à 5,0 µm.

2. Substrat selon la revendication 1, dans lequel un motif de feuille de brasure (400) pour la liaison d'un élément est formé sur la couche conductrice qui couvre la face entière pour monter l'élément du substrat en céramique.

3. Substrat en céramique (100) qui peut être utilisé de manière appropriée pour fabriquer un substrat tel que défini dans la revendication 1, et ayant un trou d'interconnexion (200) rempli avec un matériau conducteur, **caractérisé en ce qu'**une portion en céramique sur au moins l'une des faces (101, 102) du substrat en céramique présente une rugosité de surface Ra ≤ 0,8 µm, le matériau conducteur remplissant le trou d'interconnexion présent sur au moins l'une des faces de la portion en céramique qui présente la rugosité de surface Ra ≤ 0,8 µm, fait saillie à partir de la surface de la face avec une hauteur de 0,3 à 5,0 µm, et la couche conductrice n'est formée sur aucune des faces supérieure et inférieure du substrat en céramique.

4. Procédé de fabrication du substrat selon la revendication 1, comprenant les étapes consistant à :
former une couche conductrice qui couvre entièrement au moins l'une des faces sur lesquelles un matériau conducteur remplissant un trou d'interconnexion du substrat selon la revendication 3 fait saillie à partir d'une surface d'une portion en céramique du substrat avec une hauteur de 0,3 à 5,0 µm,
retirer une partie de la couche conductrice au moyen d'un processus de lithographie, pour former une couche conductrice qui couvre une surface entière d'une portion exposée du matériau conducteur qui fait saillie,
dans lequel le positionnement d'un masque photosensible à une étape d'exposition dans le processus de lithographie est réalisé sur la base d'une position d'une portion convexe de la couche conductrice qui résulte de la présence du trou d'interconnexion sur une portion sous-jacente de la couche conductrice.

5. Procédé de fabrication du substrat selon la revendication 2, comprenant les étapes consistant à :
former une couche conductrice qui couvre entièrement au moins l'une des faces sur lesquelles un matériau conducteur remplissant un trou d'interconnexion du substrat selon la revendication 3 fait saillie à partir d'une surface d'une portion en céramique du substrat avec une hauteur de 0,3 à 5,0 µm,
confirmer une position du trou d'interconnexion présent sur une portion sous-jacente de la couche conductrice sur la base d'une position d'une portion convexe de la couche conductrice qui résulte du trou d'interconnexion, et
former un motif de feuille de brasure pour la liaison d'un élément sur la couche conductrice, en relation positionnelle relative avec ledit trou d'interconnexion.
